# EUROPEAN PATENT SPECIFICATION

(11) **EP 0 487 922 B1**
(45) Date of publication and mention of the grant of the patent: **29.01.1997**
(21) Application number: 91118551.0
(22) Date of filing: 30.10.1991
(51) Int. Cl.: H01L 39/22, H01L 39/24

(54) **High speed switching electron device**
Ultraschnelle elektronische Schalteinrichtung
Dispositif électronique de commutation à grande vitesse

(30) Priority: 30.11.1990 JP 338350/90
(43) Date of publication of application: 03.06.1992
(73) Proprietor: SONY CORPORATION, Tokyo (JP)
(72) Inventor: Mukai, Mikio, Shinagawa-ku, Tokyo (JP); Ochiai, Akihiko, Shinagawa-ku, Tokyo (JP)
(74) Representative: TER MEER - MÜLLER - STEINMEISTER & PARTNER

(56) References cited:
- EP-A- 0 280 308
- PATENT ABSTRACTS OF JAPAN vol. 14, no. 108 (E-896)27 February 1990 & JP-A-1 308 086
- PATENT ABSTRACTS OF JAPAN vol. 11, no. 244 (E-530)8 August 1987 & JP-A-62 057 260
- PATENT ABSTRACTS OF JAPAN vol. 11, no. 355 (E-558)19 November 1987 & JP-A-62 131 288
- PATENT ABSTRACTS OF JAPAN vol. 9, no. 159 (E-326)4 July 1985 & JP-A-60 038 885
- IEEE TRANSACTIONS ON MAGNETICS, vol.25, no.2, March 1989, pages 1274-1277, New York, US; Kleinsasser A.W. et al:"Prospects for proximity effect superconducting FETs"
- MAVOR J. et al:Introduction to MOS LSI Design", 1983, Addison-Wesley, London, GB, pages 131-136

## Description

### Field of the Invention

The present invention generally relates to high speed switching electron devices and, more particularly, to a high speed switching electron device such as a superconductor transistor, a resonance tunnel effect transistor or the like and to a high speed memory device utilizing such high speed switching electron device.

### Description of the Prior Art

Researches and developments of superconductor transistor utilizing superconductor and semiconductor have been made so far in order to produce a ultra-high speed switching electron device.

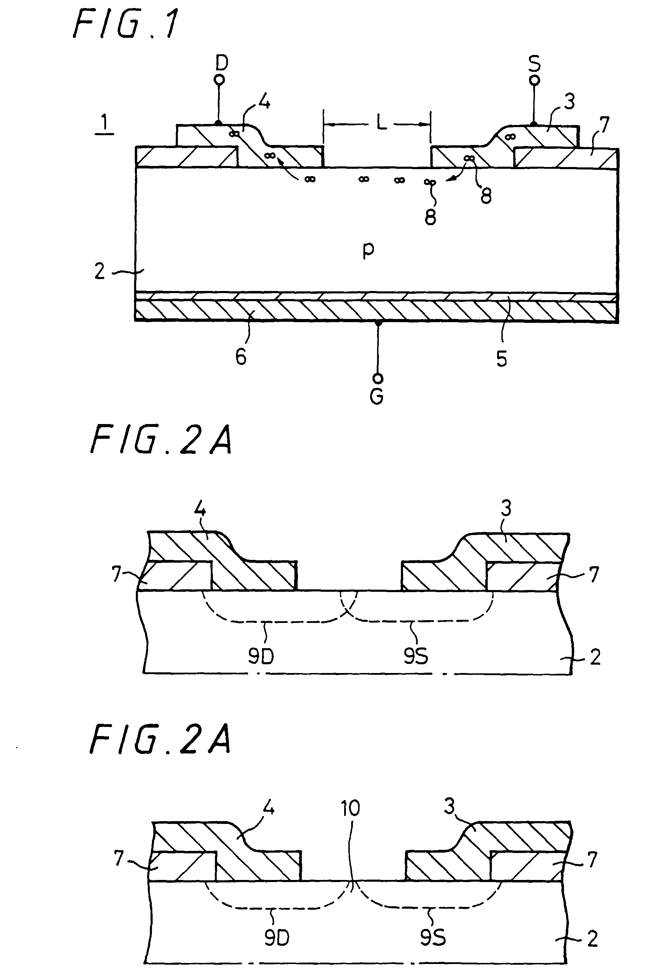

FIG. 1 shows an example of such superconductor transistor according to the prior art as disclosed in IEEE Electro Device Letters, Vol. EDL-6, No. 6, June 1985, pages 297 - 299 Referring to FIG. 1, it will be seen that a superconductor transistor 1 is comprised of a single crystalline silicon substrate 2, a source portion 3 and a drain portion 4 deposited on one major surface of the single crystalline silicon substrate 2 with a predetermined spacing L and a gate electrode 6 formed on the other major surface of the above silicon substrate 2 through an insulating film 5. In FIG. 1, reference numeral 7 depicts an insulating film.

As shown in FIGS. 2A and 2B, in this superconductor transistor 1, a superconductive current is turned on and off by controlling the areas of semi-superconductive portions 9S, 9D formed by the spread of superconductive electron pairs 8 (see FIG. 1) from the source portion 3 to the drain portion 4 of the superconductor through the silicon substrate 2 by a gate voltage. That is, under the condition that, as shown in FIG. 2A the semi--superconductive portions 9S, 9D extended from the source portion 3 and the drain portion 4 cross each other, the superconductive electron pairs 8 from the source portion 3 are flowed through the semi-superconductive portions 9S, 9D to the drain portion 4 (i.e., a so-called superconductive current is flowed), thereby the superconductor transistor 1 being turned on. Under the condition that the semi-superconductive portions 9S, 9D are not crossed each other as shown in FIG. 2B, the superconductive electron pairs 8 from the source portion 3 are broken at a portion 10 where the semi-superconductive portions 9S, 9D are not crossed each other. As a consequence, the superconductive current is not flowed and hence, the superconductor transistor 1 is turned off.

Semiconductor elements according to the prior-art technique are mainly based on the classical physical operation theory. However, as the semiconductor element becomes more and more densified, the thickness of the potential barrier is reduced and becomes substantially equal to the length of the wavelength of electron (i.e., about less than 100 Å), which unavoidably gives rise to a quantum tunnel effect. For this reason, it becomes difficult to operate the element on the basis of the principle similar to the prior art. In order to remove the above shortcomings, a variety of high speed switching electron devices utilizing the quantum tunnel effect, that is, so-called resonance tunnel effect in which only electrons of particular wavelengths can tunnel through double potential barriers have been proposed so far.

JP-A-62057260 discloses a superconducting transistor comprising superconductive source and drain portions formed on opposite major surfaces of a semiconductor channel, and a gate electrode formed on a side surface of said semiconductor channel through an insulating film.

EP-A-0280308 discloses a superconducting device comprising superconductive source and drain portions formed on side surfaces of a semiconductor columnar-shaped channel, and a gate electrode formed on an upper surface of said semiconductor channel through an insulating film.

Further, in the so-called superconductor transistor, it is required that the channel length L between the source portion 3 and the drain portion 4 is very short, that is, less than 0.2 µm.

However, in the case of the conventional structure of the high speed switching electron device shown in FIG. 1, it is extremely difficult to control the distance L (so-called channel length) between the source portion 3 and the drain portion 4 by utilizing the present fine manufacturing technology. Further, since the portion in which the semi-superconductive portions 9S, 9D extended from the source portion 3 and the drain portion 4 are constructed on one side in the lateral direction according to the above-mentioned conventional structure, operation of the channel portion to which the superconductive current is flowed is poor and the high speed switching electron device itself cannot be miniaturized without difficulty.

Furthermore, most of the semiconductor devices utilizing the above quantum tunnel effect are formed of compound semiconductors and semiconductor device formed of Si (silicon) system are not proposed substantially.

### OBJECTS AND SUMMARY OF THE INVENTION

Accordingly, it is an object of the present invention to provide a high speed switching electron device in which the aforementioned shortcomings encountered with the prior art can be eliminated.

More specifically, it is an object of the present invention to provide a high speed switching electron device, particularly, a superconductor transistor in which a superconductive operation can be controlled satisfactorily and the high speed switching device can be densified and highly integrated.

Another object of the present invention is to provide a high speed memory device which can be operated at small power and at ultra-high speed and which can be highly integrated.

As a first aspect of the present invention, a high speed switching electron device comprises the features of appended claim 1.

As a second aspect of the present invention, a high speed switching electron device comprises the features of appended claim 3.

According to a third aspect of the present invention, a high speed memory device comprises the features of appended claim 4.

The above and other objects, features, and advantages of the present invention will become apparent in the following detailed description of illustrative embodiments thereof to be read in conjunction with the accompanying drawings, in which like references are used to identify the same or similar parts in the several views.

### BRIEF DESCRIPTION OF THE DRAWINGS

FIG. 1 is a cross-sectional view illustrating a structure of a superconductor transistor which is employed as an example of a high speed switching electron device according to the prior art;
FIGS. 2A and 2B are respectively cross-sectional views used to explain operation of the superconductor transistor shown in FIG. 1;
FIG. 3 is a cross-sectional view illustrating a structure of a superconductor transistor according to a first embodiment of the present invention;
FIG. 4 is a cross-sectional view used to explain operation of the superconductor transistor of FIG. 3 according to the first embodiment of the present invention;
FIGS. 5A through 5I are respectively diagrams of the manufacturing processes and illustrating an example of the manufacturing method of the superconductor transistor of FIG. 3 according to the first embodiment of the present invention;
FIG. 6 is a cross-sectional view illustrating a structure of other superconductor transistor according to a second embodiment of the present invention;
FIG. 7 is a cross-sectional view used to explain operation of the superconductor transistor of FIG. 6 according to the second embodiment of the present invention;
FIGS. 8A through 8E are respectively diagrams of the manufacturing processes and illustrating an example of the manufacturing method of the superconductor transistor of FIG. 7 according to the second embodiment of the present invention;
FIG. 9 is cross-sectional view of a third embodiment of the superconductor transistor according to the present invention and illustrating a structure of cell of a dynamic random access memory (dynamic RAM) which is formed of the superconductor transistor of the third embodiment of the present invention and a capacitance;
FIG. 10 is a schematic diagram showing an equivalent circuit of the dynamic RAM of FIG. 9 according to the third embodiment of the present invention;

### DESCRIPTION OF THE PREFERRED EMBODIMENTS

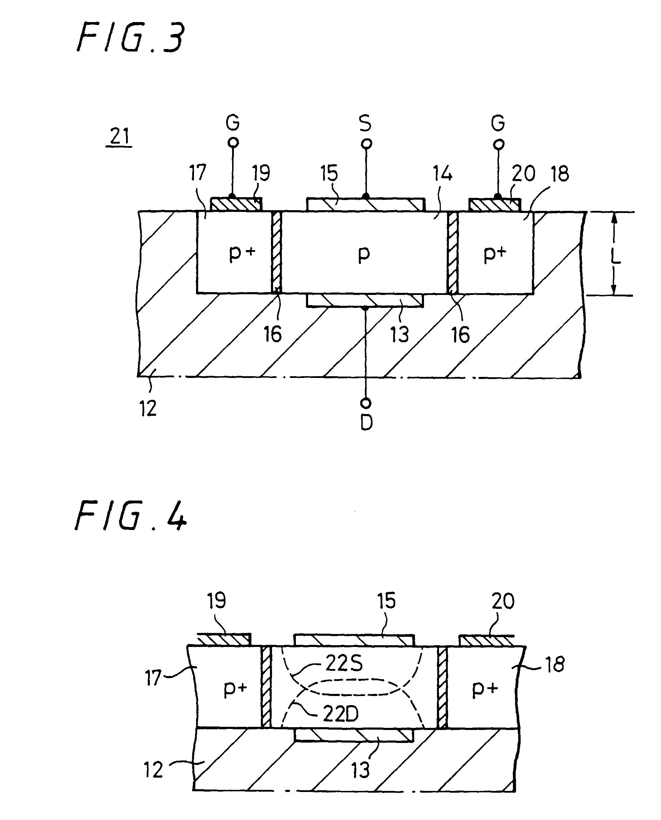

Referring to the drawings in detail, and initially to FIG. 3, a first embodiment of the superconductor transistor according to the present invention will be described hereinafter. The most specific feature of the first embodiment lies in that the superconductor transistor of this embodiment is formed by effectively utilizing the features of a semiconductor on insulator (SdI) structure.

As shown in FIG. 3, a drain portion 13 of a predetermined width formed of a superconductive material is formed on an insulator 12 formed of an SiO₂ or the like, and a first conductivity type semiconductor thin film of predetermined impurity concentration forming a channel portion, that is, p type single crystalline silicon thin film 14 having a impurity concentration of about 10¹⁹ cm⁻³ is formed on the drain portion 13. A superconductive source portion 15 is formed on the upper surface of this silicon thin film 14 so as to oppose the drain portion 13. The width of the silicon thin film 14 forming the channel portion in the lateral direction becomes wider than those of the source portion 15 and the drain portion 13.

Further, p type or n type silicon thin films of low resistance, that is, in this embodiment, p type high concentration impurity regions 17 and 18 forming one portion of gate electrodes are respectively formed on both outer side surfaces of the silicon thin film 14 forming the channel portion through an insulating film 16 made of, for example, SiO₂ or the like. Aℓ electrodes 19, 20 forming gate electrodes are respectively formed on the high concentration impurity regions 17, 18, thereby a superconductor transistor 21 being constructed. It is preferred that the film thickness of the silicon thin film 14 forming a channel length L is less than 0.1 µm. Also, it is preferred that the outer surfaces of the high concentration impurity regions 17, 18 are encircled by the SiO₂ insulator 12. The above superconductor transistor 21 may be constructed by effectively utilizing a manufacturing method of an SOl substrate of, for example, bonding type.

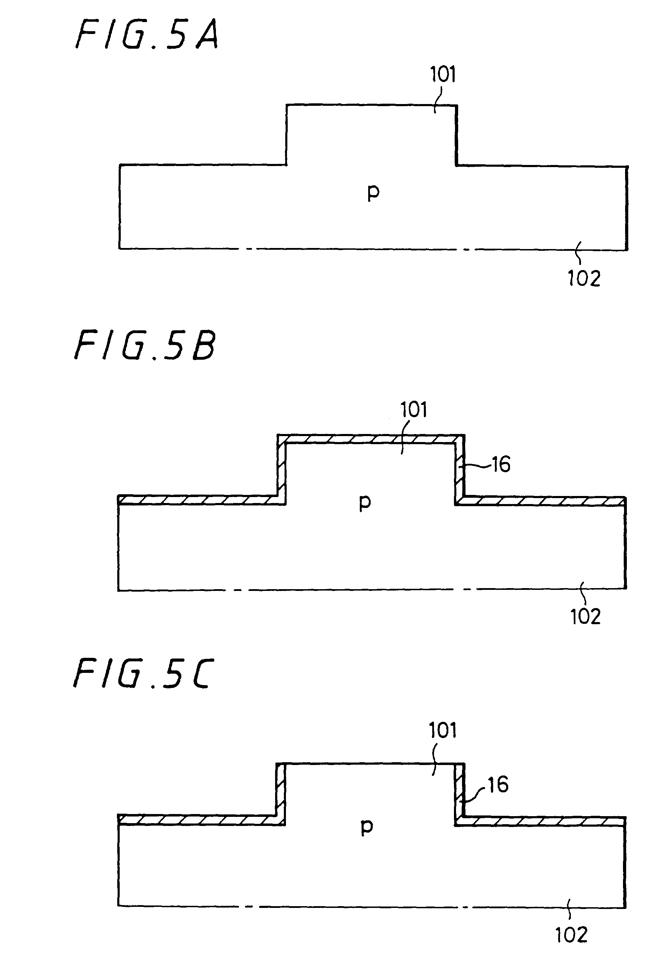

An example of this manufacturing method will be described with reference to FIGS. 5A through 5I.

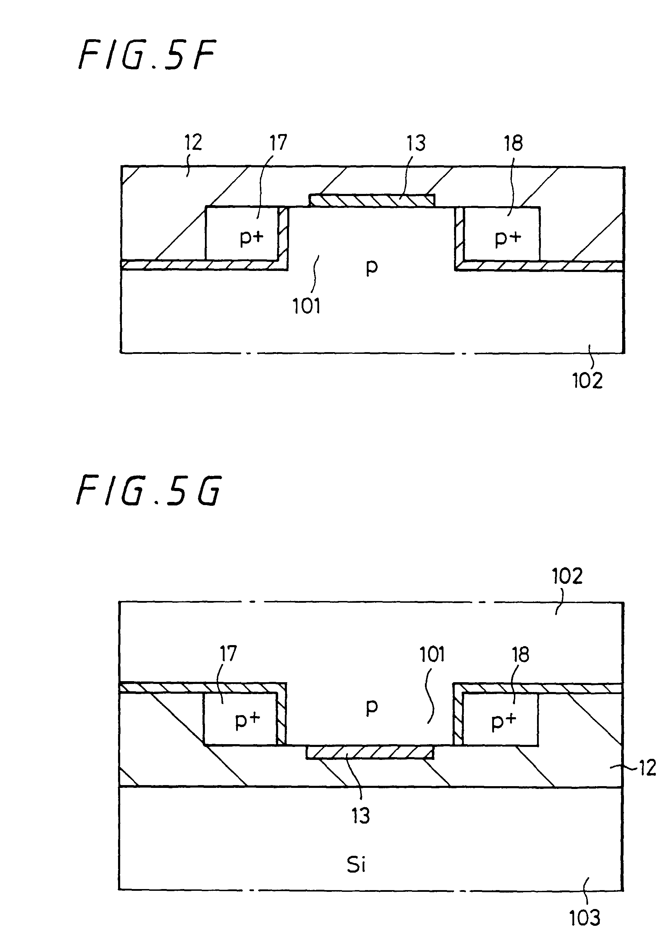

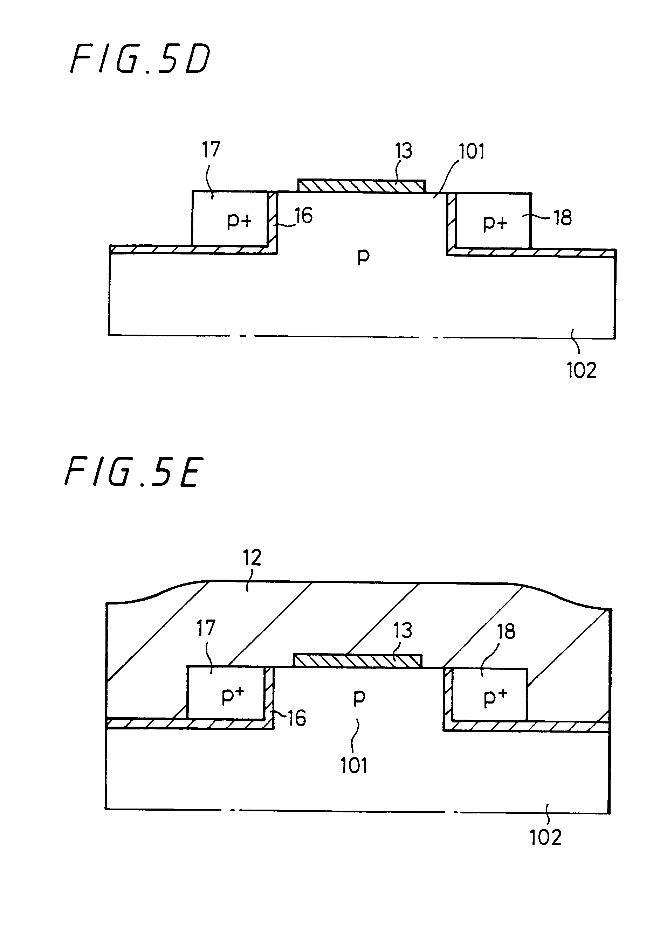

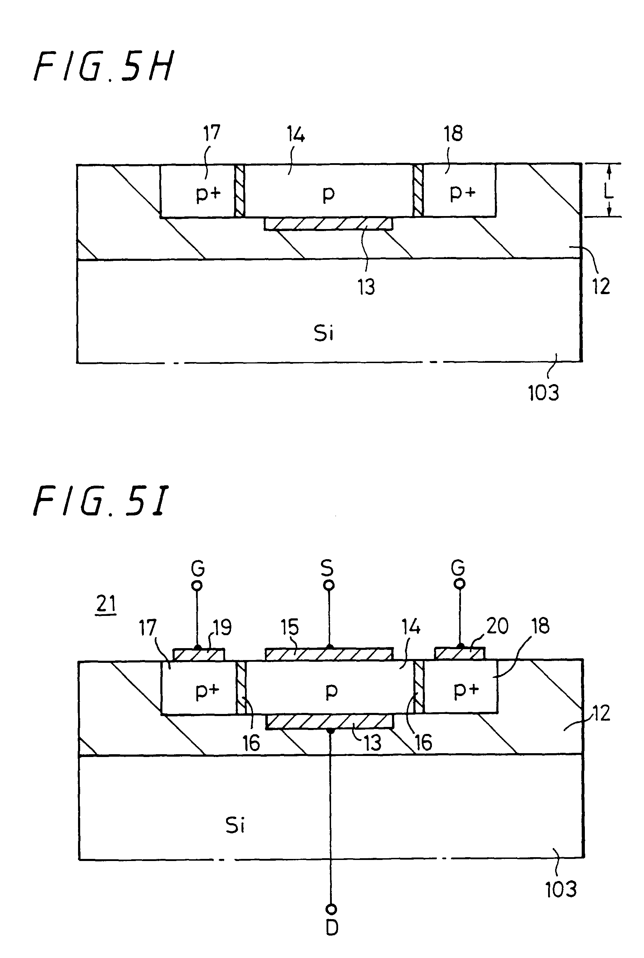

As shown in FIG. 5A, a single crystalline silicon substrate 102 of first conductivity type (e.g., p type) in which a convex-shaped portion 101 is formed on one major surface by some suitable process such as a selective etching process or the like is formed, and then the surface of this silicon substrate 102 is oxidized to form the SiO₂ film 16 (see FIG. 5B). Then, only the SiO₂ film 16 on the convex-shaped portion 101 is removed by the selective etching process as shown in FIG. 5C. Then, as shown in FIG. 5D, p type high concentration impurity regions 17, 18 made of polycrystalline silicon forming one part of gate electrode are respectively formed on both sides of the convex-shaped portion 101 through the SiO₂ film 16, and the drain portion 13 formed of superconductive material is formed on the convex-shaped portion 101 as shown in FIG. 5D. After the insulating film 12 made of SiO2 or the like is deposited on the entire surface of the silicon substrate 102 so as to cover the convex-shaped portion 101 as shown in FIG. 5E, the surface of the insulating film 12 is made flat by the planarization process as shown in FIG. 5F. Then, other silicon substrate 103 is bonded to the upper surface of the insulating film 12 as shown in FIG. 5G, and FIG. 5G shows the condition such that the product is inverted after the silicon substrate 103 is bonded to the insulating film 12 by the bonding-process. In the next process, one silicon substrate 102 is ground and polished so as to expose the p type high concentration impurity regions 17, 18 which become gate electrodes, whereby the convex-shaped portion 101 is presented as the silicon thin film 14 of channel length L as shown in FIG. 5H. Thereafter, as shown in FIG. 5I, the superconductive source portion 15 is formed on the upper surface of the silicon thin film 14 and the Aℓ electrodes 19, 20 forming the gate electrodes are formed on the upper surfaces of the p type high concentration impurity regions 17, 18, thereby the target superconductor transistor 21 shown in FIG. 3 being obtained.

In the thus arranged superconductor transistor 21, since the superconductive source and drain portions 15 and 13 are formed on the upper and lower surfaces of the p type silicon thin film channel portion 14, owing to the superconductive proximity effect, superconductive electron pairs from the superconductive source and drain portions 15, 13 are extended to the upper and lower sides in the channel portion 14 to thereby form semi-superconductive portions 22S, 22D which are expanded in an opposing relation to each other as shown in FIG. 4. The semi-superconductive portions 22S, 22D are controlled by a gate voltage supplied to the high concentration impurity regions 17, 18 formed at both sides of the channel portion 14 so that the superconductive current is turned on and off. Accordingly, since this transistor 21 is operated in a superconductive fashion, the power consumption thereof is considerably small and the electric resistance thereof is substantially zero, thereby achieving the ultra-high speed operation of the transistor 21.

Further, since the features of the SOI structure are effectively utilized such that the opposing source and drain portions 15 and 13 are formed on the upper and lower sides of the silicon thin film 14 which forms the channel portion and the semi-superconductive portions 22S and 22D at the sides of the source and drain portions 15 and 13 are extended over the whole widths of the source and drain portions 15 and 13 in contact with the silicon film 14 by the gate voltage in an opposing fashion, the two semi-superconductive portions 22S and 22D can be overlapped sufficiently by the small area, thereby facilitating the control of the superconductive current flowing between the source and drain portions 15 and 13.

Furthermore, since the superconductor transistor of this embodiment makes effective use of the SOI structure, the film thickness of the silicon thin film 14 can be reduced to less than 0.1 µm, which can realize with ease the channel length L of less than 0.2 µm that is one of the requirements as the superconductor transistor.

As described above, according to this embodiment, the superconductive operation can be controlled satisfactorily and this kind of superconductor transistor can be densified and highly integrated.

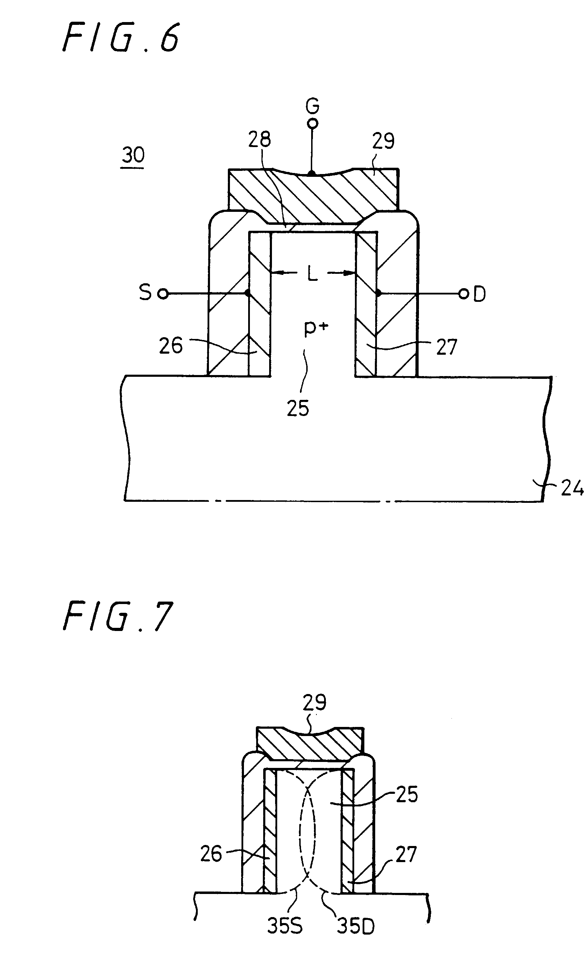

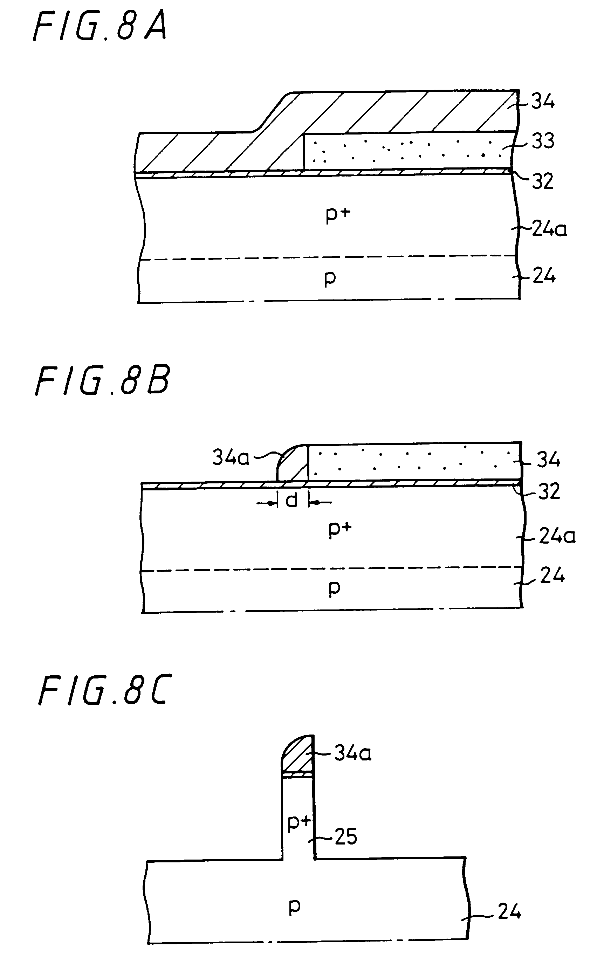

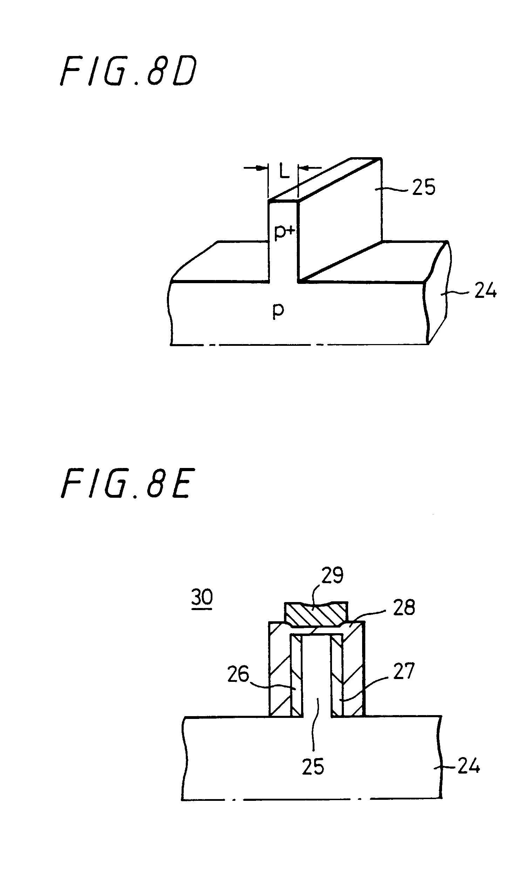

FIG. 6 shows a second embodiment of the superconductor transistor according to the present invention.

In this embodiment, as shown in FIG. 6, a p⁺ type silicon columnar-shaped channel portion 25 of a predetermined width L is integrally formed on one major surface of a semiconductor substrate of a first conductivity type, for example, p type silicon substrate 24, and superconductive source and drain portions 26 and 27 are formed on both side surfaces of the columnar-shaped channel portion 25. Further, a gate electrode 29 made of Aℓ semiconductor or the like is formed on the upper surface of the columnar-shaped channel portion 25 through an insulating film 28 made of SiO₂ or the like, thereby a superconductor transistor 30 being constructed. The channel portion 25 is formed of a p⁺ type silicon of proper impurity concentration (e.g., about 10¹⁹ cm⁻³ ) and the channel length L is less than 0.2 µm.

An example of a method of manufacturing this superconductor transistor 30 will be described with reference to FIGS. 8A to 8E.

Referring initially to FIG. 8A, an impurity diffusion region 24a of impurity concentration of about 10¹⁹ cm⁻³ is formed on one major surface of a p type single crystalline silicon substrate 24, and a polycrystalline silicon film 33 treated by the patterning-process is formed on one major surface of the impurity diffusion region 24a through an insulating film 32 formed of SiO₂ or the like. An SiO₂ film 34 is deposited on the whole surface thereof by, for example, the chemical vapor deposition (CVD) process. Then, the whole surface of the SiO₂ film 34 is etched by the anisotropy etching process (e.g., reactive ion etching (RIE) process or the like) to thereby form an SiO₂ side wall portion 34a on an end face of the polycrystalline silicon film 33 as shown in FIG. 8B. The side wall portion 34a is formed such that the width d (= channel length L) thereof becomes, for example, about 0.15 µm. Then, as shown in FIG. 8C, the polycrystalline silicon film 34 is removed, the impurity diffusion region 24a on the silicon substrate 24 is removed by the etching-process using the side wall portion 34a as a mask, and then the side wall portion 34a is removed, thereby forming the columnar-shaped channel portion 25 of 0.1 µm wide as shown in FIG. 8D.

In accordance with the succeeding process, the superconductive source and drain portions 26 and 27 are formed on both side surfaces of the columnar-shaped channel portion 25. Further, the SiO₂ film 28 is formed on the whole surface and the gate electrode 29 is formed on the upper surface of the columnar-shaped channel portion 25, thereby the superconductor transistor 30 shown in FIG. 8E being formed.

In the thus arranged superconductor transistor 30, since the opposing superconductive source and drain regions 26 and 27 are formed on both side surfaces of the p type silicon columnar-shaped channel portion 25, semi-superconductive portions 35S, 35D are extended toward the right and left sides in the columnar-shaped channel portion 25 in an opposing relation to each other owing to the superconductive proximity effect as shown in FIG. 7. The semi-superconductive portions 35S, 35D are controlled by the gate voltage supplied to the gate electrode 29 formed on the upper surface of the columnar-shaped channel portion 25, thereby the superconductive current being turned on and off. Since this transistor 30 is operated in a superconductive fashion, the power consumption thereof is considerably small and the electric resistance thereof is substantially zero, thereby achieving the ultra-high speed operation of the transistor 30. Further, since the opposing source and drain portions 26 and 27 are formed on both side surfaces of the columnar-shaped channel portion 25 so that the semi-superconductive portions 35S and 35D on the sides of the source and drain portions 26 and 27 are extended over the whole areas of the source and drain portions 26 and 27 in contact with the columnar-shaped channel portion 25 by the gate voltage in an opposing fashion, the two semi-superconductive portions 35S and 35D can be overlapped sufficiently by the small area, thereby facilitating the control of the superconductive current flowing between the source and drain portions 26 and 27. Furthermore, since the width of the columnar-shaped channel portion 25 can be reduced to less than 0.1 µm, which can realize with ease the channel length L of less than 0.2 µm that is one of the requirements of the superconductor transistor. Also in accordance with this embodiment, the superconductor transistor can be densified and highly integrated.

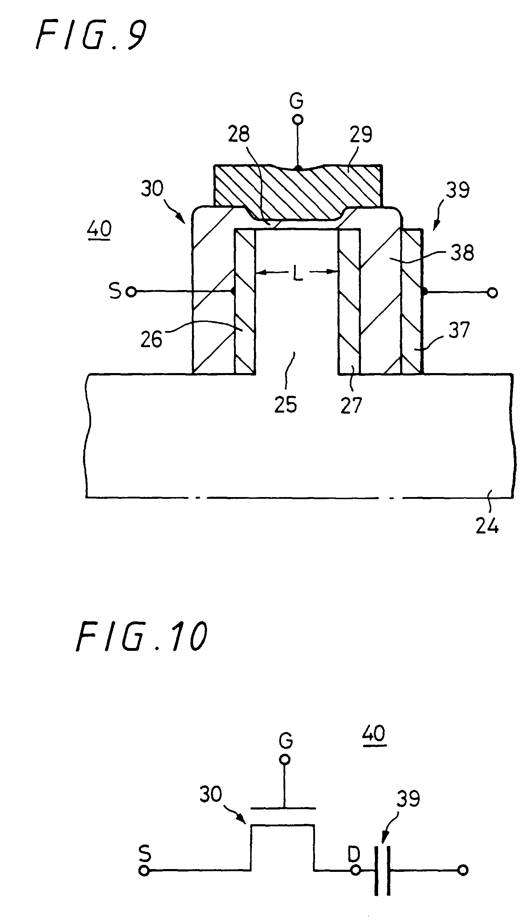

FIG. 9 shows a third embodiment of the superconductor element according to the present invention which is suitably applied to a dynamic RAM cell. This embodiment makes effective use of the superconductor transistor 30 of the columnar-shaped channel structure of FIG. 6. In FIG. 9, like parts corresponding to those of FIG. 6 are marked with the same references and therefore need not be described in detail.

In this embodiment, as shown in FIG. 9, the p type silicon columnar-shaped channel portion 25 having a channel length L of less than 0.2 µm is integrally formed on one major surface of the semiconductor substrate of first conductivity type, for example, the p type silicon substrate 24, and the superconductive source and drain portions 26 and 27 are formed on both sides of the columnar-shaped channel portions 25. Then, the gate electrode 29 made of Aℓ or the like is formed on the upper surface of the channel portion 25 through the insulating film 28 to thereby form the superconductor transistor 30. Further, a superconductive electrode 37 is formed on the outside of the drain portion 27 of the superconductor transistor 30 through a dielectric film 38 made of SiO₂ or the like so as to oppose the drain portion 27. Thus, the superconductive drain portion 27, the dielectric film 38 and the superconductive electrode 37 constitute a capacitance 39. In this case, it is preferred that the superconductive electrode 37 and the silicon substrate 24 are electrically insulated from each other by means of an insulating film or the like, though not shown. A superconductive dynamic RAM cell 40 of so-called one transistor and one capacitance type is constructed in this fashion. Incidentally, the interconnection of ordinary metal wires is utilized in the portion in which a current need not be flowed, that is, the portion in which the voltage is turned on and off (e.g., gate portion). FIG. 10 shows a diagram of an equivalent circuit of the dynamic RAM cell 40 shown in FIG. 9.

Since the dynamic RAM cell 40 of the present invention is composed of the superconductor transistor 30 and the capacitance 37 having the superconductor electrode 37, the power consumption of the dynamic RAM cell 40 is very small and the electric resistance thereof is substantially zero, thereby the ultra-high speed operation of the dynamic RAM cell 40 being made possible. Further, since the superconductive electrode 37 is directly formed on the insulating film which covers the drain electrode 27 of the columnar-shaped channel type superconductor transistor 30 from a structure standpoint, the dynamic RAM cell 40 can be manufactured with ease, densified and highly integrated.

Therefore, as set out above, according to the high speed switching electron devices utilizing the superconductor of the present invention, the ultra-high speed operation becomes possible and the superconductor operation at the channel portion can be controlled satisfactorily. Further, the channel length of less than 0.2 µm can be realized with ease. Thus, it is possible to provide the high speed electron device which can be suitably densified and highly integrated.

Further, according to the high speed memory device of the present invention, the power consumption thereof can be reduced considerably and the ultra-high speed operation becomes possible. In addition, the high speed memory device of the present invention can be manufactured with ease, the memory device can be densified and highly integrated.

Furthermore, according to the high speed electron device utilizing the resonance tunnel effect of the present invention, this high speed electron device can be operated at very high speed, manufactured with ease, densified and highly integrated.

Having described the preferred embodiments of the invention with reference to the accompanying drawings, it is to be understood that the invention is not limited to those precise embodiments and that various changes and modifications thereof could be effected by one skilled in the art without departing from the spirit or scope of the invention as defined in the appended claims.

## Claims

1. A high speed switching electron device comprising:
a semiconductor channel portion (14);
superconductive source and drain portions (15, 13) formed on opposite major surfaces of said semiconductor channel portion (14); and
a first gate electrode (17, 19) formed on a first side surface of said semiconductor channel portion (14) through an insulating film (16);
**characterized by**
a second gate electrode (18, 20) formed on a side surface of said semiconductor channel portion (14) through an insulating film (16) opposite to said first side surface.

2. A manufacturing method for a device as claimed in claim 1, comprising the following steps:
forming a convex-shaped portion (101) on one major surface of a substrate (102);
forming an insulating film (16) on said surface excluding said convex-shaped portion,
forming gate electrodes (17, 18) on both sides of said convex-shaped portion through said insulating film;
forming a drain portion (13) on said convex-shaped portion;
depositing an insulating film (12) on the entire surface of said substrate (102) so as to cover said convex-shaped portion;
removing said substrate (102) and said insulating film (16) so as to expose said gate electrodes (17, 18); and
forming a superconductive source portion (15) on said convex-shaped portion opposite to said drain portion (13).

3. A high speed switching electron device comprising:
a semiconductor columnar-shaped channel portion (25);
superconductive source and drain portions (26, 27) formed on side surfaces of said semiconductor columnar-shaped channel portion (25); and
a gate electrode (29) formed on an upper surface of said semiconductor columnar-shaped channel portion (25) through an insulating film (28);
**characterized in that**
said semiconductor columnar-shaped channel portion (25) and
said superconductive source and drain portions (26, 27) are formed on a substrate (24);
said substrate (24) being of a first conductivity type and
said semiconductor columnar-shaped channel portion (25) being of a second conductivity type.

4. A high speed memory device (40) comprising:
the high speed switching electron device according to claim 3,
and a capacitance (39) which is formed of a superconductor (37) provided outside said drain portion (27) through a dielectric film (38).

5. A manufacturing method for a device as claimed in claim 3, comprising the following steps:
forming on a substrate (24) an impurity region (24a) of an impurity concentration different from the impurity concentration of said substrate (24);
forming a mask (34a) on said impurity region (24a); removing said impurity region (24a) by etching using said mask (34a);
removing said mask (34a) thereby forming a columnar-shaped channel portion (25);
forming source and drain portions (26, 27) on both side surfaces of said columnar-shaped channel portion (25);
forming an insulating film (28) on the whole surface of said columnar-shaped channel portion (25) and said source and drain portions (26, 27); and
forming a gate electrode (29) on the upper surface of said columnar-shaped channel portion (25) through said insulating film (28).

6. The method of claim 5, wherein forming said mask (34a) comprises the steps of:
forming a polycrystalline silicon film (33) treated by the patterning-process on one major surface of said impurity region (24a);
depositing an SiO₂ film (34) on the whole surface thereof;
etching the whole surface of said SiO₂ film (34) by the anisotropy etching process to thereby forming an SiO₂ side wall portion (34a) usable as said mask on an end face of said polycrystalline silicon film (33); and
removing said polycrystalline silicon film (33).

7. The method of claims 5 or 6 further comprising the following step for the manufacture of a device as claimed in claim 4: forming an electrode (37) on the outside of said drain portion (27) through a dielectric film (38) so as to oppose said drain portion (27), the drain portion (27), the dielectric film (38) and the electrode (37) constituting a capacitance (39).

## Patentansprüche

1. Ultraschnelles elektronisches Schaltbauteil mit:
- einem halbleitenden Kanalbereich (14);
- supraleitenden Source- und Drainbereichen (15, 13), die auf entgegengesetzten Hauptflächen des halbleitenden Kanalbereichs (14) ausgebildet sind; und
- einer ersten Gateelektrode (17, 19), die auf einer ersten Seitenfläche des halbleitenden Kanalbereichs (14) über einen Isolierfilm (16) hinweg ausgebildet ist;
**gekennzeichnet durch**
- eine zweite Gateelektrode (18, 20), die auf einer Seitenfläche des halbleitenden Kanalbereichs (14) über einen Isolierfilm (16) hinweg abgewandt von der ersten Seitenfläche ausgebildet ist.

2. Herstellverfahren für ein Bauteil nach Anspruch 1, mit den folgenden Schritten:
- Herstellen eines konvexen Bereichs (101) auf einer Hauptfläche eines Substrats (102);
- Herstellen eines Isolierfilms (16) auf dieser Fläche mit Ausnahme des konvexen Bereichs;
- Herstellen von Gateelektroden (17, 18) an den beiden Seiten des konvexen Bereichs über den Isolierfilm hinweg;
- Herstellen eines Drainbereichs (13) auf dem konvexen Bereich;
- Abscheiden eines Isolierfilms (12) auf der gesamten Fläche des Substrats (102), um den konvexen Bereich zu bedecken;
- Entfernen des Substrats (102) und des Isolierfilms (16), um die Gateelektroden (17, 18) freizulegen; und
- Herstellen eines supraleitenden Sourcebereichs (15) auf dem konvexen Bereich, abgewandt vom Drainbereich (13).

3. Ultraschnelles elektronisches Schaltbauteil mit:
- einem halbleitenden, säulenförmigen Kanalbereich (25);
- halbleitenden Source- und Drainbereichen (26, 27), die auf Seitenflächen des halbleitenden, säulenförmigen Kanalbereichs (25) ausgebildet sind; und
- einer Gateelektrode (29), die auf der Oberfläche des halbleitenden, säulenförmigen Kanalbereichs (25) über einen Isolierfilm (28) hinweg ausgebildet ist;
**dadurch gekennzeichnet,** dass
- der halbleitende, säulenförmige Kanalbereich (25) und der supraleitende Source- und Drainbereich (26, 27) auf einem Substrat (24) ausgebildet sind;
- das Substrat (2) von erstem Leitungstyp ist und
- der halbleitende, säulenförmige Kanalbereich (25) von zweitem Leitungstyp ist.

4. Ultraschnelles Speicherbauteil (40) mit:
- einem ultraschnellen elektronischen Schaltbauteil gemäß Anspruch 3 und
- einer Kapazität (39), die über einem dielektrischen Film (38) auf einem Supraleiter (37) ausgebildet ist, der außerhalb des Drainbereichs (27) vorhanden ist.

5. Herstellverfahren für ein Bauteil nach Anspruch 3, mit den folgenden Schritten:
- Herstellen eines Fremdstoffbereichs (24a) mit einer Fremdstoffkonzentration, die sich von der eines Substrats (24) unterscheidet, auf dem Substrat (24);
- Herstellen einer Maske (34a) auf dem Fremdstoffbereich (24a);
- Entfernen des Fremdstoffbereichs (24a) durch einen Ätzvorgang unter Verwendung der Maske (24a) ;
- Entfernen der Maske (34a), um dadurch einen säulenförmigen Kanalbereich (25) herzustellen;
- Herstellen von Source- und Drainbereichen (26, 27) auf den beiden Seitenflächen des säulenförmigen Kanalbereichs (25);
- Herstellen eines Isolierfilms (28) auf der gesamten Fläche des säulenförmigen Kanalbereichs (25) sowie den Source- und Drainbereichen (26, 27); und
- Herstellen einer Gateelektrode (29) auf der Oberfläche des säulenförmigen Kanalbereichs (25) über dem Isolierfilm (28).

6. Verfahren nach Anspruch 5, bei dem das Herstellen der Maske (34a) die folgenden Schritte umfasst:
- Herstellen eines durch einen Mustererzeugungsprozess bearbeiteten polykristallinen Siliziumfilms (33) auf einer Hauptfläche des Fremdstoffbereichs (34a) ;
- Abscheiden eines SiO₂-Films (34) auf der gesamten Oberfläche desselben;
- Ätzen der gesamten Fläche des SiO₂-Films (34) durch einen anisotropen Ätzprozess, um dadurch einen als Maske verwendbaren SiO₂-Seitenwandbereich (34a) an einer Endfläche des polykristallinen Siliziumfilms (33) herzustellen; und
- Entfernen des polykristallinen Siliziumfilms (33).

7. Verfahren nach einem der Ansprüche 5 oder 6, ferner mit dem folgenden Schritt zum Herstellen eines Bauteils nach Anspruch 4:
- Herstellen einer Elektrode (37) an der Außenseite des Drainbereichs (27) über einem dielektrischen Film (38) in solcher Weise, dass sie dem Drainbereich (27) gegenübersteht, wobei dieser Drainbereich (27) , der dielektrische Film (38) und die Elektrode (37) eine Kapazität (39) bilden.

## Revendications

1. Dispositif électronique de commutation à grande vitesse comportant:
une portion semiconductrice (14) en canal;
des portions supraconductrices (15, 13), formant source et formant drain, formées sur les surfaces principales opposées de ladite portion semiconductrice formant (14) en canal; et
une première électrode de grille (17, 19) formée sur une première surface latérale de ladite portion semiconductrice (14) en canal avec interposition d'un film isolant (16);
caractérisé
par une seconde électrode de grille (18, 20) formée sur une surface latérale, opposée à ladite première surface latérale, de ladite portion semiconductrice (14) en canal, avec interposition d'un film isolant (16).

2. Procédé de fabrication d'un dispositif comme revendiqué dans la revendication 1, comportant les étapes suivantes:
former une portion de forme convexe (101) sur une première surface principale d'un substrat (102); former un film isolant (16) sur ladite surface, à l'exclusion de ladite portion de forme convexe,
former des électrodes de grille (17, 18) des deux côtés de ladite portion de forme convexe, avec interposition dudit film isolant;
former une portion formant drain (13) sur ladite portion de forme convexe;
déposer un film isolant (12) sur toute la surface dudit substrat (102) de façon à couvrir ladite portion de forme convexe;
enlever ledit substrat (32) et ledit film isolant (16) de façon à faire apparaître lesdites électrodes de grille (17, 18); et
former une portion supraconductrice (15), formant source, sur ladite portion de forme convexe, du côté opposé à ladite portion formant drain (13).

3. Dispositif électronique de commutation à grande vitesse comportant:
une portion semiconductrice en canal (25), en forme de colonne;
des portions supraconductrices (26, 27), formant source et formant drain, formées sur les surfaces latérales de ladite portion semiconductrice en canal (25) en forme de colonne; et
une électrode de grille (20) formée sur une surface supérieure de ladite portion semiconductrice en canal (25) en forme de colonne, avec interposition d'un film isolant (28);
caractérisé par le fait que
ladite portion semiconductrice en canal (25) en forme de colonne et lesdites portions supraconductrices (26, 27), formant source et formant drain, sont formées sur un substrat (24);
ledit substrat (24) étant d'un premier type de conductivité et ladite portion semiconductrice en canal (25) en forme de colonne étant d'un second type de conductivité.

4. Dispositif de mémoire à grande vitesse (40) comportant:
le dispositif électronique de commutation à grande vitesse conforme à la revendication 3 et un condensateur (39) formé d'un supraconducteur (37) prévu à l'extérieur de ladite portion formant drain (27) avec interposition d'un film diélectrique (38).

5. Procédé de fabrication d'un dispositif comme revendiqué dans la revendication 3, comportant les étapes suivantes:
former sur un substrat (24) une région d'impuretés (24a) d'une concentration en impuretés différente de la concentration en impuretés desdits substrats (24);
former, un masque (34) sur ladite région d'impuretés (24a);
enlever ladite région d'impuretés (24a) par attaque utilisant ledit masque (34a);
enlever ledit masque (34a), formant ainsi une portion en canal (25) en forme de colonne;
former les portions formant source et formant drain (26, 27) sur les deux surfaces latérales de ladite portion en canal (25) en forme de colonne;
former un film isolant (28) sur toute la surface de ladite portion en canal (25) en forme de colonne et sur lesdites portions (26, 27) formant source et formant drain; et
former une électrode de grille (29) sur la surface supérieure de ladite portion en canal (25) en forme de colonne avec interposition dudit film isolant (28).

6. Procédé de la revendication 5, dans lequel le fait de former ledit masque (34) comporte les étapes consistant à:
former un film de silicium polycristallin (33), traité par le processus de formation des motifs, sur une première surface principale de ladite région d'impuretés (24a);
poser un film de SiO₂ (34) sur toute sa surface;
attaquer toute la surface dudit film de SiO₂ (34) par le processus d'attaque anisotropique pour former ainsi une portion de paroi latérale de SiO₂ (34a) utilisable comme dit masque sur une face d'extrémité dudit film de silicium polycristallin (33); et
enlever ledit film de silicium polycristallin (33).

7. Procédé des revendications 5 ou 6, comportant en outre l'étape suivante pour la fabrication d'un dispositif comme revendiqué dans la revendication 4:
former une électrode (37) sur l'extérieur de ladite portion formant drain (27) avec interposition d'un film diélectrique (38) pour venir du côté opposé à ladite portion formant drain (27), la portion formant drain (27), le film diélectrique (38) et l'électrode (37) constituant un condensateur (39).
